# EUROPEAN PATENT APPLICATION

(11) **EP 4 373 124 A1**
(43) Date of publication of application: **22.05.2024**
(21) Application number: 22842157.4
(22) Date of filing: 13.07.2022
(51) Int. Cl.: H04N 25/70, H01L 21/336, H01L 27/146, H01L 29/786, H04N 23/00

(54) **OPTICAL SEMICONDUCTOR MODULE AND SAMPLE OBSERVATION DEVICE**

(30) Priority: 13.07.2021 JP 2021115855
(71) Applicant: Kyocera Corporation, Kyoto-shi Kyoto 612-8501 (JP)
(72) Inventor: KITAMURA, Shigeki, Kyoto-shi, Kyoto 612-8501 (JP); KANDA, Eiji, Kyoto-shi, Kyoto 612-8501 (JP); SHIMA, Nobuyuki, Kyoto-shi, Kyoto 612-8501 (JP)
(74) Representative: TBK
(86) International application number: PCT/JP2022/027616
(87) International publication number: WO 2023/286815

(57) **Abstract**

An optical semiconductor module includes a substrate including a first surface, a plurality of pixel units in a matrix on the first surface and each including an optical semiconductor component, a drive circuit on the first surface to provide a power supply voltage to the plurality of pixel units and transmit or receive an image signal to or from the plurality of pixel units, a plurality of external connection terminals on the first surface, a plurality of drive wires on the first surface and connecting the drive circuit and the plurality of external connection terminals, and antenna wiring being looped and surrounding the plurality of pixel units, the drive circuit, the plurality of external connection terminals, and the plurality of drive wires in a plan view. The antenna wiring includes two ends connected to the drive circuit.

## Description

### TECHNICAL FIELD

The present disclosure relates to an optical semiconductor module and a sample observation apparatus.

### BACKGROUND OF INVENTION

A known optical semiconductor module and a known sample observation apparatus are described in, for example, Patent Literature 1.

### CITATION LIST

### PATENT LITERATURE

Patent Literature 1: Japanese Unexamined Patent Application Publication No. 2018-78130

### SUMMARY

In an aspect of the present disclosure, an optical semiconductor module includes a substrate including a first surface, a plurality of pixel units in a matrix on the first surface and each including an optical semiconductor component, a drive circuit on the first surface to provide a power supply voltage to the plurality of pixel units and transmit or receive an image signal to or from the plurality of pixel units, a plurality of external connection terminals on the first surface, a plurality of drive wires on the first surface and connecting the drive circuit and the plurality of external connection terminals, and antenna wiring being looped and surrounding the plurality of pixel units, the drive circuit, the plurality of external connection terminals, and the plurality of drive wires in a plan view. The antenna wiring includes two ends connected to the drive circuit.

In an aspect of the present disclosure, a sample observation apparatus includes the above optical semiconductor module, a transparent container to contain a medium including a sample, a light source that emits light toward the transparent container, a slit member that allows passage of scattering light resulting from the light being scattered by the medium, a control board including a radiator that radiates an electromagnetic wave toward the antenna wiring, and a flexible wired circuit board connecting the optical semiconductor module and the control board. The optical semiconductor component includes a photodetector. The optical semiconductor module is located between the light source and the slit member to receive the scattering light passing through the slit member.

### BRIEF DESCRIPTION OF THE DRAWINGS

The objects, features, and advantages of the present disclosure will become more apparent from the following detailed description and the drawings.
FIG. 1 is a plan view of an optical semiconductor module according to an embodiment of the present disclosure.
FIG. 2 is a partially enlarged plan view of the optical semiconductor module according to the embodiment of the present disclosure.
FIG. 3 is a cross-sectional view taken along line III-III in FIG. 1.
FIG. 4 is a plan view of an optical semiconductor module according to another embodiment of the present disclosure.
FIG. 5 is a plan view of the optical semiconductor module according to the other embodiment of the present disclosure as viewed in a direction different from the direction in FIG. 4A.
FIG. 6 is a plan view of an optical semiconductor module according to still another embodiment of the present disclosure.
FIG. 7 is an exploded perspective view of a sample observation apparatus according to an embodiment of the present disclosure.
FIG. 8 is a cross-sectional view of the sample observation apparatus according to the embodiment of the present disclosure.
FIG. 9 is a partially enlarged cross-sectional view of the sample observation apparatus according to the embodiment of the present disclosure.

### DESCRIPTION OF EMBODIMENTS

An optical semiconductor module and a sample observation apparatus with the structures that form the basis of an optical semiconductor module and a sample observation apparatus according to one or more embodiments of the present disclosure will first be described.

Various imaging devices have been developed for use in sample observation apparatuses for observing samples such as specimens. For example, Patent Literature 1 describes an imaging device including a solid-state image sensor and antenna wiring surrounding the imaging surface of the solid-state image sensor to at least transmit an image from the solid-state image sensor or receive external electric power.

Such a known imaging device may include a drive circuit for driving the solid-state image sensor. To avoid overlapping with the antenna wiring, the drive circuit may be positioned inefficiently, increasing the size of the imaging device. Such a known imaging device may also be affected greatly by parasitic capacitance between signal wiring connected to the drive circuit and the antenna wiring. The solid-state image sensor may operate unstably or transmit images or receive external electric power unstably.

The optical semiconductor module and the sample observation apparatus according to one or more embodiments of the present disclosure will now be described with reference to the accompanying drawings. Each figure referred to below illustrates main components and other elements of the optical semiconductor module and the sample observation apparatus according to one or more embodiments of the present disclosure. In one or more embodiments of the present disclosure, the optical semiconductor module and the sample observation apparatus may include known components not illustrated in the figures, such as circuit boards, wiring conductors, control ICs, and LSI circuits. Each figure referred to below is schematic and is not drawn to scale relative to, for example, the actual positions and dimensional ratios of components of the optical semiconductor module and the sample observation apparatus.

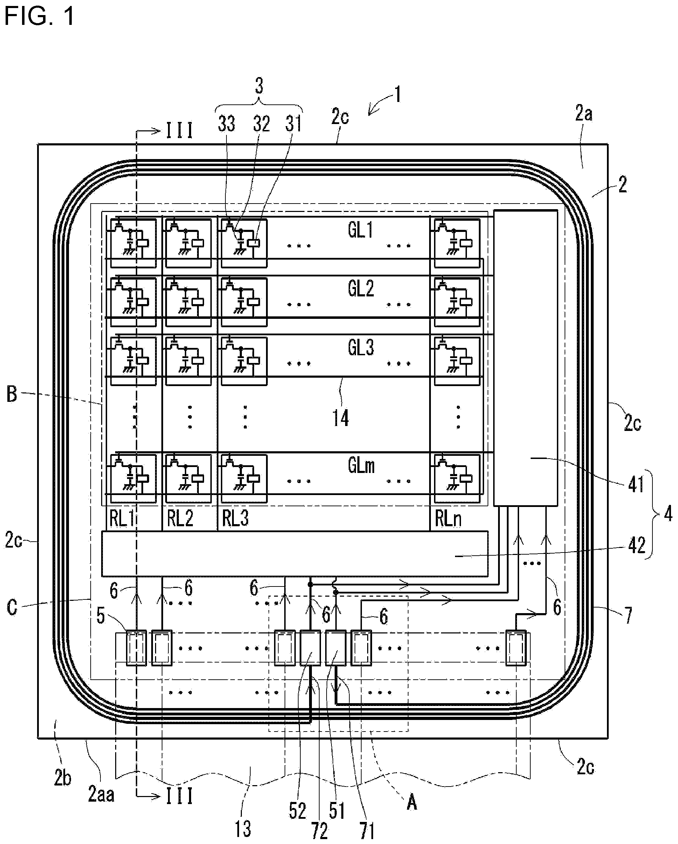

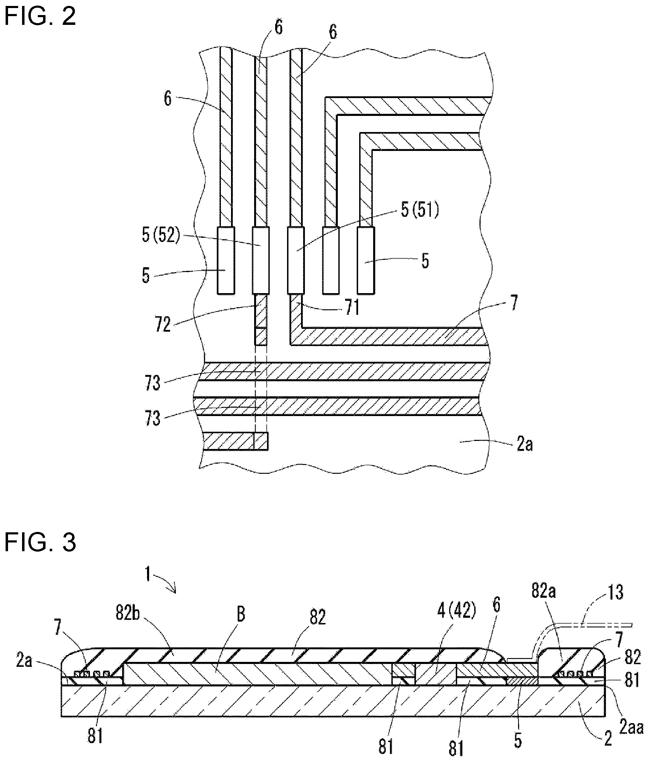

FIG. 1 is a plan view of an optical semiconductor module according to an embodiment of the present disclosure. FIG. 2 is a partially enlarged plan view of the optical semiconductor module according to the embodiment of the present disclosure. FIG. 3 is a cross-sectional view taken along line III-III in FIG. 1. FIG. 2 is an enlarged plan view of portion A in FIG. 1. In FIGs. 1 and 2, an insulating layer located on a first surface of a substrate and covering multiple pixel units, a drive circuit, multiple drive wires, and antenna wiring is not illustrated.

In the present embodiment, an optical semiconductor module 1 includes a substrate 2, multiple pixel units 3, a drive circuit 4, multiple external connection terminals 5, multiple drive wires 6, and antenna wiring 7.

The substrate 2 includes a first surface (first main surface) 2a, a second surface (second main surface) 2b opposite to the first surface 2a, and third surfaces (side surfaces) 2c connecting the first surface 2a and the second surface 2b. The substrate 2 may be, for example, a triangular plate, a rectangular plate including a square plate, a trapezoidal plate, a hexagonal plate, a circular plate, or an elliptic plate, or in any other shape.

The substrate 2 is made of, for example, a glass material or a resin material. The substrate 2 may be transparent. Examples of the glass material used for the substrate 2 include borosilicate glass, crystallized glass, and quartz. Examples of the resin material used for the substrate 2 include an epoxy resin, a polyimide resin, a polyamide resin, an acrylic resin, and a polycarbonate resin.

As illustrated in, for example, FIG. 1, the pixel units 3 are in a matrix on the first surface 2a of the substrate 2. Each pixel unit 3 includes an optical semiconductor component 31. The optical semiconductor component 31 may be a light receiver (also referred to as a photodetector) or a light emitter. The optical semiconductor component 31 may include both a photodetector and a light emitter.

The photodetector may include, for example, a photodiode (PD). The light emitter may include a self-luminous light emitter such as a light-emitting diode (LED) or a semiconductor laser diode (LD). In the example described below, the optical semiconductor component 31 is a photodetector, or more specifically, a photodiode. In other words, the optical semiconductor module 1 is a photodetection module. The multiple pixel units 3 may be hereafter collectively referred to as a photodetection unit B.

The optical semiconductor module 1 includes multiple gate signal lines GL1 to GLm and multiple read signal lines RL1 to RLn. The gate signal lines GL1 to GLm extend in a predetermined first direction (lateral direction in FIG. 1). The read signal lines RL1 to RLn extend in a second direction (vertical direction in FIG. 1) intersecting with the first direction. The pixel units 3 are at intersections between the gate signal lines GL1 to GLm and the read signal lines RL1 to RLn. The gate signal lines GL1 to GLm may be hereafter collectively referred to as gate signal lines GL without distinguishing the individual gate signal lines. The read signal lines RL1 to RLn may be hereafter collectively referred to as read signal lines RL without distinguishing the individual read signal lines.

Each pixel unit 3 includes a charge storage 32 and a switching element 33 in addition to the photodetector 31, as illustrated in, for example, FIG. 1. The charge storage 32 stores electric charge resulting from photoelectric conversion performed by the photodetector 31. The switching element 33 enters a conductive state (on-state) in response to a signal through the corresponding gate signal line GL and outputs a read signal, an electric signal based on the amount of charge in the charge storage 32, to the corresponding read signal line RL.

The charge storage 32 may include a capacitor. The switching element 33 may include a thin-film transistor (TFT). The TFT may include a semiconductor film (also referred to as a channel) made of, for example, amorphous silicon (a-Si) or low-temperature polycrystalline silicon (LTPS). The TFT may include three terminals that are a gate electrode, a source electrode, and a drain electrode. The TFT switches between a conductive state (on-state) and a nonconductive state (off-state) between the source electrode and the drain electrode in response to the voltage applied to the gate electrode. The TFT may be an n-channel TFT or a p-channel TFT. The switching element 33 may include a CMOS transfer gate. For the switching element 33 including the TFT, the switching element 33 may be referred to as a TFT 33.

The drive circuit 4 is located on the first surface 2a of the substrate 2. The drive circuit 4 may be located on the first surface 2a directly or across an insulating layer 81 made of, for example, silicon oxide (SiO₂), silicon nitride (SiNx), or an acrylic resin. The insulating layer 81 may include a single insulating layer, or multiple insulating layers stacked on one another.

The drive circuit 4 includes, for example, a TFT and a wiring conductor. When the substrate 2 is made of a glass material and the TFT in the drive circuit 4 includes a semiconductor film made of LTPS, the drive circuit 4 can be formed directly on the first surface 2a with a thin film formation method such as chemical vapor deposition (CVD).

The drive circuit 4 supplies electric power to the photodetection unit B and transmits or receives an image signal to or from the photodetection unit B. For the optical semiconductor module 1 being a photodetection module, the drive circuit 4 receives a read signal (also referred to as an image signal) from the photodetection unit B. The drive circuit 4 may output the received image signal to an external control board (not illustrated).

The drive circuit 4 includes a gate driver 41 and a selector 42. The gate driver 41 is connected to the gate signal lines GL and provides gate voltages to the TFTs 33 in the pixel units 3 through the gate signal lines GL. The gate driver 41 provides gate signals to each row of the matrix of the pixel units 3. The selector 42 is connected to the read signal lines RL1 to RLn and receives the read signal output from the TFTs 33 in the pixel units 3 through the read signal lines RL.

The external connection terminals 5 are located on the first surface 2a. The external connection terminals 5 may be located on the first surface 2a directly or across the insulating layer 81. The external connection terminals 5 are connected (electrically connected) to the electrodes of an external circuit board 13 with a conductive bond such as solder. Two intermediate terminals 51 and 52 adjacent to and between the external connection terminals 5 are electrically connected to the antenna wiring 7. The intermediate terminals 51 and 52 may be located in the middle of the array of the external connection terminals 5. The external connection terminals 5 are connected to an external control board with the external circuit board 13. The intermediate terminals 51 and 52 may be covered with the external circuit board 13 for protection. The intermediate terminals 51 and 52 are connected to an antenna capacitor that stores electric charge obtained with the antenna wiring 7 or to a processing circuit that processes a received wave component obtained with the antenna wiring 7. The external circuit board 13 may transfer image signals obtained by the pixel units 3 to the external control board. The external circuit board 13 may transfer a control signal generated by the external control board to the optical semiconductor module 1. The external circuit board 13 may be, for example, a flexible printed circuit (FPC) board. The antenna capacitor, the processing circuit, or both may be located on the first surface 2a or may be located on the external control board with the external circuit board 13 in between.

The external connection terminals 5 and the intermediate terminals 51 and 52 are made of a conductive material such as a metal material. The external connection terminals 5 and the intermediate terminals 51 and 52 may each include a single metal layer or multiple metal layers stacked on one another. The external connection terminals 5 and the intermediate terminals 51 and 52 may be made of, for example, Al, Al/Ti, Ti/Al/Ti, Mo, Mo/Al/Mo, MoNd/AlNd/MoNd, Cu, Cr, Ni, or Ag. The stack of Mo/Al/Mo includes a Mo layer, an Al layer, and a Mo layer in this order. MoNd is an alloy of Mo and Nd. The same applies to the others.

The drive wires 6 are located on the first surface 2a and connect the drive circuit 4 and the external connection terminals 5. The intermediate terminals 51 and 52 are also connected to the drive circuit 4 with the drive wires 6. The drive wires 6 connected to the intermediate terminals 51 and 52 and the drive wires 6 connected to the external connection terminals 5 may be located on the first surface 2a directly or across the insulating layer 81.

The drive wires 6 are made of a conductive material such as a metal material. The drive wires 6 may each include a single metal layer or multiple metal layers stacked on one another. The drive wires 6 may be made of, for example, Al, Al/Ti, Ti/Al/Ti, Mo, Mo/Al/Mo, MoNd/AlNd/MoNd, Cu, Cr, Ni, or Ag.

The antenna wiring 7 is located on the substrate 2. In the present embodiment, the antenna wiring 7 is located on the first surface 2a of the substrate 2. The antenna wiring 7 may be located on the first surface 2a directly or across the insulating layer 81.

As illustrated in, for example, FIG. 1, the antenna wiring 7 is looped (or coiled or spiral-shaped). The antenna wiring 7 surrounds the photodetection unit B, the drive circuit 4, the external connection terminals 5, and the drive wires 6 in a plan view. As illustrated in, for example, FIG. 2, the antenna wiring 7 includes its two ends 71 and 72 connected to the intermediate terminals 51 and 52. The antenna wiring 7 may be connected to the drive circuit 4 without the intermediate terminals 51 and 52. The photodetection unit B, the drive circuit 4, the external connection terminals 5, and the drive wires 6 may be hereafter collectively referred to as a surface circuit C.

In a plan view, the antenna wiring 7 may be looped one or more times along the periphery of the surface circuit C as illustrated in, for example, FIG. 1. The antenna wiring 7 looped multiple times along the periphery of the surface circuit C has a greater wire length, with improved transmission characteristics or reception characteristics. In the present embodiment, the antenna wiring 7 receives external electric power. The electric power received by the antenna wiring 7 may be supplied to the drive circuit 4 for driving the pixel units 3. The electric power received by the antenna wiring 7 may be used to provide a constant bias voltage to the optical semiconductor components 31 (photodiode) through bias lines 14. The power reception with the antenna wiring 7 may be performed through, for example, electromagnetic waves radiated from an external radiator (not illustrated) producing an induced current in the antenna wiring 7 by electromagnetic induction.

The antenna wiring 7 is made of a conductive material such as a metal material. Examples of the conductive material used for the antenna wiring 7 include a metal such as Al or Cu, and an alloy of these metals.

In the present embodiment, the optical semiconductor module 1 includes the antenna wiring 7 surrounding the surface circuit C in a plan view. This structure allows the surface circuit C to be efficiently located in the area surrounded by the antenna wiring 7 on the first surface 2a, reducing the size of the optical semiconductor module 1.

The optical semiconductor module 1 includes the antenna wiring 7 not overlapping the drive wires 6 in a plan view, with less parasitic capacitance between the antenna wiring 7 and the drive wires 6. This allows the drive circuit 4 and the pixel units 3 to operate stably and the antenna wiring 7 to operate stably.

The optical semiconductor module 1 may include the antenna wiring 7 overlapping wiring on the external circuit board 13 in a plan view as illustrated in, for example, FIG. 1. However, the parasitic capacitance between the antenna wiring 7 and the wiring on the external circuit board 13 can be easily reduced by increasing the distance between the antenna wiring 7 and the external circuit board 13 or placing a substance with low capacitance between the antenna wiring 7 and the external circuit board 13. The parasitic capacitance between the antenna wiring 7 and the wiring on the external circuit board 13 is less likely to affect the operation of the optical semiconductor module 1.

The antenna wiring 7 surrounding the surface circuit C can function as a guard ring that reduces static electricity and unintended external electromagnetic waves affecting the surface circuit C (particularly the pixel units 3). The optical semiconductor module 1 including the antenna wiring 7 surrounding the surface circuit C can operate stably.

For the antenna wiring 7 looped one or more times on the first surface 2a along the periphery of the surface circuit C, the antenna wiring 7 includes one or more overlapping areas 73 in which portions of the antenna wiring 7 overlap each other as illustrated in, for example, FIG. 2. The total of the overlapping areas 73 is smaller than the total of overlapping areas in which the antenna wiring 7 overlaps the drive wires 6 when the external connection terminals 5 are located outside the area surrounded by the antenna wiring 7. The parasitic capacitance in the overlapping areas 73 is relatively low and is less likely to affect the operation of the optical semiconductor module 1. Each overlapping area 73 includes overlapping portions of the antenna wiring 7 across an inorganic insulating film made of, for example, silicon oxide (SiO₂) or silicon nitride (SiNx), or a resin insulating film. For the overlapping area 73 including the portions of the antenna wiring 7 across a resin insulating film, the resin insulating film may be thicker to easily reduce parasitic capacitance affecting the operation.

The antenna wiring 7 may be located at the periphery of the first surface 2a as illustrated in, for example, FIG. 1. In this case, the area surrounded by the antenna wiring 7 is larger, easily allowing efficient placement of the surface circuit C. The antenna wiring 7 can have a greater wire length with improved transmission characteristics.

For the substrate 2 being a polygonal plate, such as a triangular, rectangular, trapezoidal, or hexagonal plate, the external connection terminals 5 may be located adj acent to a first side 2aa of the first surface 2a as illustrated in, for example, FIG. 1. This structure facilitates connection between some of the external connection terminals 5 and the electrodes of the external circuit board 13. This structure also reduces the likelihood that other wiring (e.g., drive wires 6) between the external connection terminals 5 and the antenna wiring 7 causes parasitic capacitance between the wiring on the external circuit board 13 and the drive wires 6. The optical semiconductor module 1 can thus operate stably.

The antenna wiring 7 may be looped circularly along the periphery of the surface circuit C, independently of the shape of the first surface 2a. This can reduce the electric resistance of the antenna wiring 7 to improve the power reception efficiency of the antenna wiring 7.

The drive circuit 4 may include a capacitor (not illustrated) that stores electric power supplied from the antenna wiring 7. The drive circuit 4 may supply power stored in the capacitor to the pixel units 3 when power reception by the antenna wiring 7 is (temporarily) unstable. This stabilizes the power supply voltage and allows the optical semiconductor module 1 to operate stably.

The photodetection module 1 may include, on the first surface 2a, an insulating layer 82 covering the photodetection unit B, the drive circuit 4, the drive wires 6, and the antenna wiring 7. This structure reduces the likelihood of the pixel units 3, the drive circuit 4, the drive wires 6, and the antenna wiring 7 separating from the substrate 2, thus improving the reliability of the optical semiconductor module 1. The insulating layer 82 may be made of a transparent resin material. Examples of the transparent resin material used for the insulating layer 82 include a fluororesin, a silicone resin, an acrylic resin, a polycarbonate resin, and a polymethyl methacrylate resin. The insulating layer 82 may include a single insulating layer, or multiple insulating layers stacked on one another.

Each external connection terminal 5 may include its peripheral portion partially covered with the insulating layer 82 in a plan view. This reduces the likelihood of the external connection terminals 5 separating from the substrate 2, thus improving the reliability of the optical semiconductor module 1.

The insulating layer 82 may include a low capacitance portion 82a and a high capacitance portion 82b. For the substrate 2 being a polygonal plate, the low capacitance portion 82a may be between the first side 2aa of the first surface 2a and the external connection terminals 5 in a plan view. The low capacitance portion 82a may be made of a resin material having a lower dielectric constant than the resin material used for the high capacitance portion 82b. As illustrated in FIG. 3, the low capacitance portion 82a may be made of the same material as the high capacitance portion 82b and may be thicker than the high capacitance portion 82b.

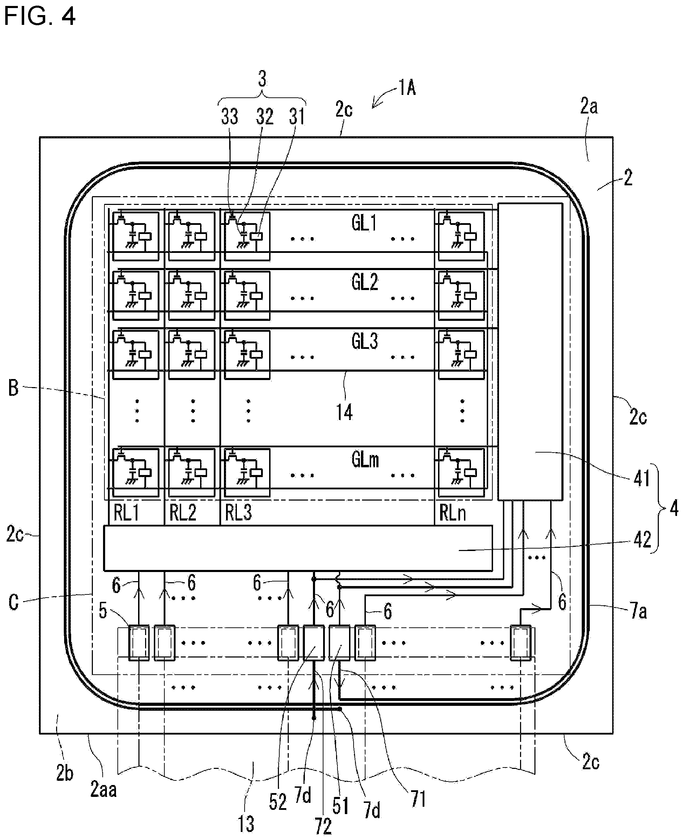

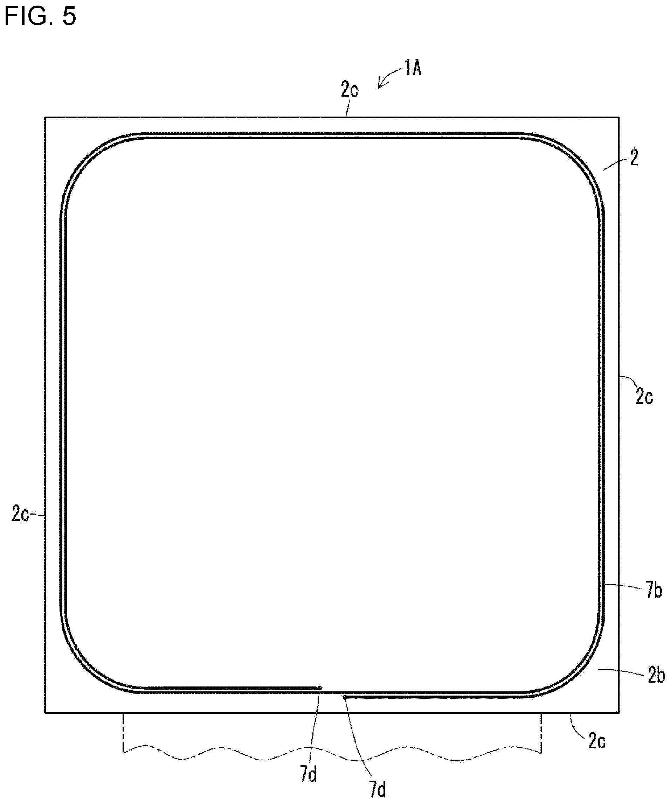

An optical semiconductor module according to another embodiment of the present disclosure will now be described. FIG. 4 is a plan view of the optical semiconductor module according to the embodiment of the present disclosure. FIG. 5 is a plan view of the optical semiconductor module according to the embodiment of the present disclosure as viewed in a direction different from the direction in FIG. 4. In the present embodiment, an optical semiconductor module 1A has the same structure as the optical semiconductor module 1 except for the antenna wiring 7. The same reference numerals denote the same or similar components as those of the optical semiconductor module 1, and such components will not be described in detail.

In the optical semiconductor module 1A, the antenna wiring 7 includes a portion (also referred to as front wiring) 7a located on the first surface 2a and a portion (also referred to as back wiring) 7b located on the second surface 2b. The back wiring 7b may be located on the second surface 2b directly or across an insulating layer made of, for example, silicon oxide (SiO₂) or silicon nitride (SiNx). The back wiring 7b may extend along the periphery of the second surface 2b. The back wiring 7b may be looped at least once along the periphery of the surface circuit C in a plan view. As illustrated in, for example, FIGs. 4 and 5, the front wiring 7a and the back wiring 7b may be connected with feedthrough conductors 7d extending through the substrate 2 in the thickness direction. The front wiring 7a and the back wiring 7b may be connected with side wiring on the third surfaces 2c of the substrate 2.

The optical semiconductor module 1A can have, without increasing the area of the frame on the first surface 2a, the antenna wiring 7 with a greater length (a greater sum of the length of the front wiring 7a and the length of the back wiring 7b) and thus with improved transmission characteristics, than the antenna wiring 7 including the front wiring 7a alone.

The optical semiconductor module 1A includes the front wiring 7a looped fewer times along the periphery of the surface circuit C. The photodetection module 1 can thus have a narrower frame without reducing the length of the antenna wiring 7. With fewer loops of the front wiring 7a and more loops of the back wiring 7b, the antenna wiring 7 can maintain its length and avoid deterioration in the transmission characteristics.

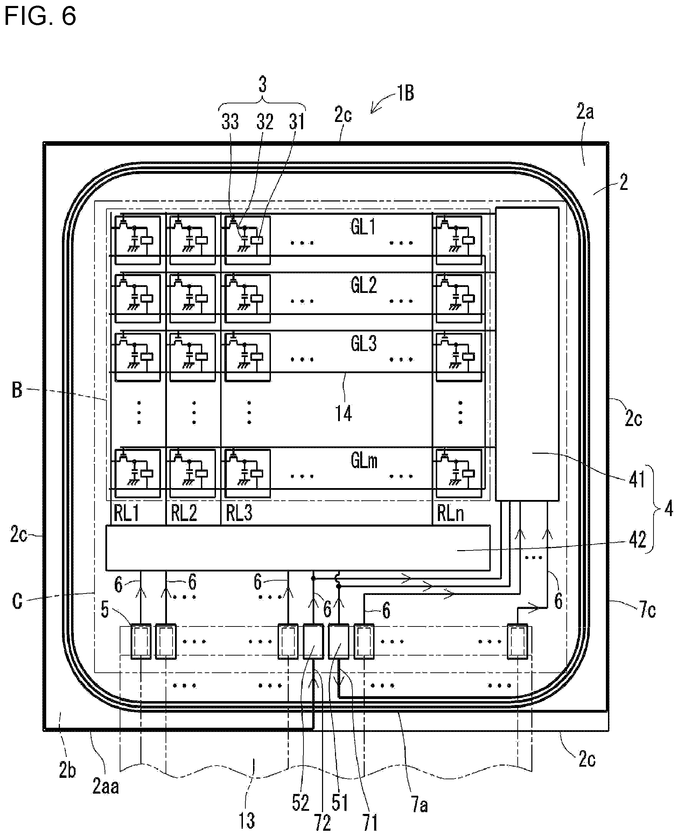

An optical semiconductor module according to still another embodiment of the present disclosure will now be described. FIG. 6 is a plan view of the optical semiconductor module according to the embodiment of the present disclosure. In the present embodiment, an optical semiconductor module 1B has the same structure as the optical semiconductor module 1 except for the antenna wiring 7. The same reference numerals denote the same or similar components as those of the optical semiconductor module 1, and such components will not be described in detail.

In the optical semiconductor module 1B, the antenna wiring 7 includes front wiring 7a located on the first surface 2a and portions (also referred to as side wiring) 7c located on the third surfaces 2c. The side wiring 7c may be located on the third surfaces 2c directly or across an insulating layer made of, for example, silicon oxide (SiO₂) or silicon nitride (SiNx). As illustrated in, for example, FIG. 6, the side wiring 7c extends on the third surfaces 2c along the periphery of the substrate 2. The side wiring 7c may be looped at least once along the periphery of the substrate 2.

The optical semiconductor module 1B can have, without increasing the area of the frame on the first surface 2a, the antenna wiring 7 with a greater length (a greater sum of the length of the front wiring 7a and the length of the side wiring 7c) and thus with improved transmission characteristics, than the antenna wiring 7 including the front wiring 7a alone.

The optical semiconductor module 1B includes the front wiring 7a looped fewer times along the periphery of the surface circuit C. The photodetection module 1 can thus have a narrower frame without reducing the length of the antenna wiring 7. With fewer loops of the front wiring 7a and more loops of the side wiring 7c, the antenna wiring 7 can maintain its length and avoid deterioration in the transmission characteristics.

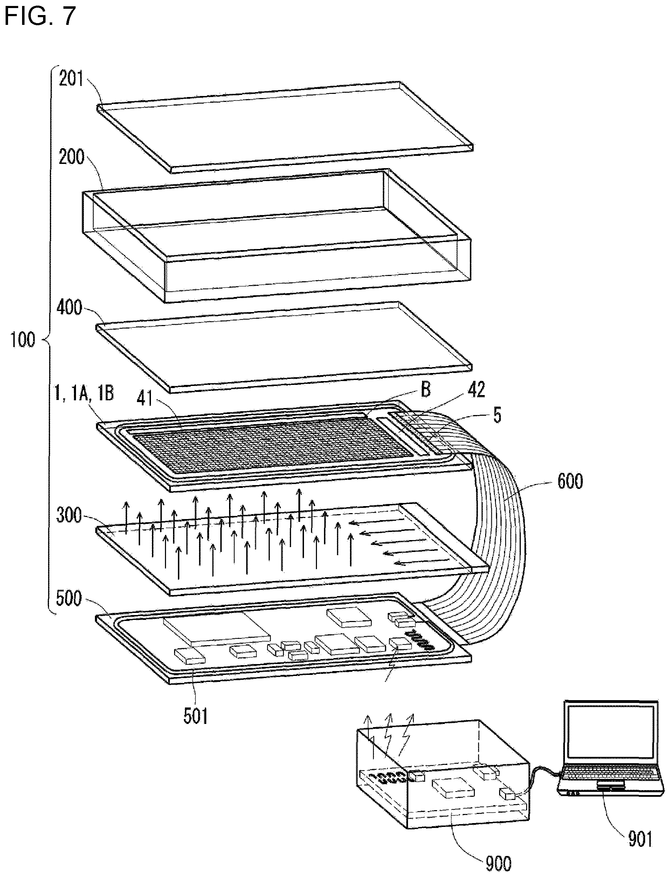

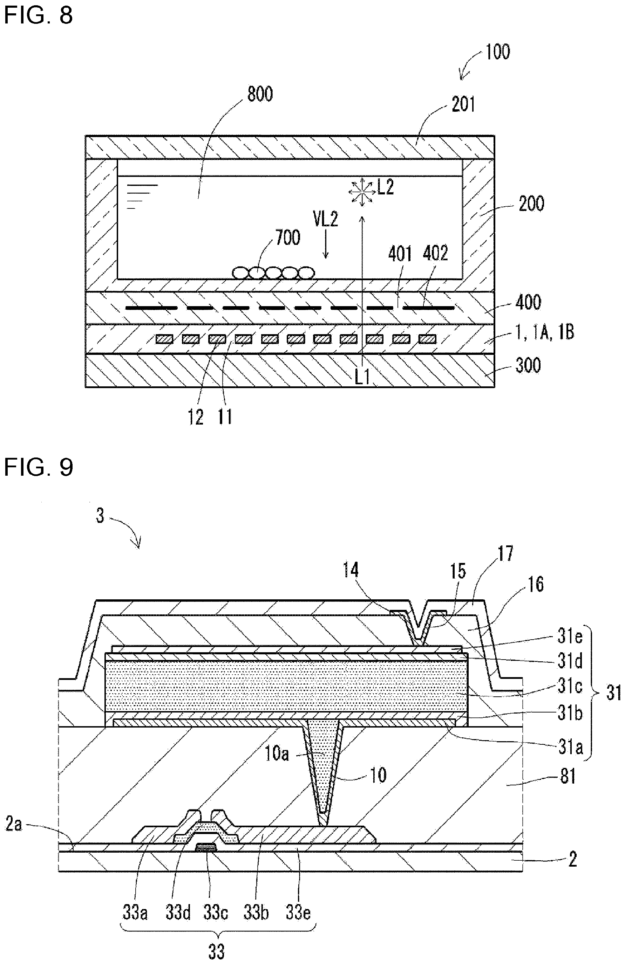

A sample observation apparatus according to an embodiment of the present disclosure will now be described. FIG. 7 is an exploded perspective view of the sample observation apparatus according to the present embodiment. FIG. 8 is a cross-sectional view of the sample observation apparatus according to the embodiment of the present disclosure. FIG. 9 is a partially enlarged cross-sectional view of the sample observation apparatus according to the embodiment of the present disclosure. FIG. 8 schematically illustrates an optical semiconductor module, without illustrating components other than pixel units. FIG. 9 is a cross-sectional view of a photodetector and a TFT in a pixel unit, illustrating their structures.

As illustrated in, for example, FIG. 7, a sample observation apparatus 100 according to the present embodiment includes the optical semiconductor module 1, 1A, or 1B, a container 200, a light source 300, a slit member 400, a control board 500, and a flexible printed circuit board 600.

The optical semiconductor module 1, 1A, or 1B functions as a photodetection module. The optical semiconductor component 31 includes a photodetector. The optical semiconductor module 1, 1A, or 1B may be hereafter referred to as a photodetection module 1, 1A, or 1B. The optical semiconductor component 31 may be referred to as a photodetector 31.

The photodetector 31 includes a photodiode. The photodetector 31 may be a PIN photodiode or a PN photodiode. In the example described below, the photodetector 31 is a PIN photodiode. The PIN photodiode includes an intrinsic semiconductor layer (i-type semiconductor layer) between a p-n junction. The PIN photodiode including the intrinsic semiconductor layer has a larger depletion layer than a PN photodiode when receiving a reverse voltage. The PIN photodiode thus has faster responsiveness than a PN photodiode. The PIN photodiode has a smaller dark current than a PN photodiode when receiving a reverse voltage.

Each pixel unit 3 in the photodetection module 1, 1A, or 1B is located on the first surface 2a of the substrate 2 as illustrated in, for example, FIG. 9. In FIG. 9, the charge storage 32 in the pixel unit 3 is not illustrated. The TFT 33 includes a source electrode 33a, a drain electrode 33b, a gate electrode 33c, a semiconductor film (channel) 33d, and a gate insulating film 33e. The source electrode 33a and the drain electrode 33b may be made of a metal such as Ta, Nd, W, Ti, Mo, Al, Cr, or Ag, or an alloy of these metals. The photodetector 31 may include a passivation layer (not illustrated). The passivation layer may be located on the first surface 2a and cover the TFT 33.

The photodetector 31 is electrically connected to the drain electrode 33b of the TFT 33 with a lower contact hole 10. The photodetector 31 includes a lower electrode layer 31a, a lower extrinsic semiconductor layer 31b, an intrinsic semiconductor layer 31c, an upper extrinsic semiconductor layer 31d, and an upper electrode layer 31e stacked in this order from the substrate 2. The lower contact hole 10 may include a part of the lower electrode layer 31a on the inner surface of a recess formed by removing a predetermined portion of the insulating layer 81 by, for example, etching, and an insulating filler 10a filling a space defined by the lower electrode layer 31a. The lower electrode layer 31a may be made of a metal such as Ta, Nd, W, Ti, Mo, Al, Cr, or Ag, or an alloy of these metals. The lower extrinsic semiconductor layer 3 1b may be made of, for example, n+-type a-Si. The intrinsic semiconductor layer 31c may be made of, for example, intrinsic Si (i-type Si). The upper extrinsic semiconductor layer 31d may be made of, for example, p+-type a-Si. The upper electrode layer 31e may be made of, for example, indium tin oxide (ITO). The insulating filler 10a may be made of an organic material such as an acrylic resin, a silicone resin, a polyimide, a polyamide, a polyimide amide, benzocyclobutene, polysiloxane, or polysilazane. The photodetector 31 (PIN photodiode) includes the lower electrode layer 31a, the lower extrinsic semiconductor layer 31b, the intrinsic semiconductor layer 31c, the upper extrinsic semiconductor layer 31d, and the upper electrode layer 31e. The photodetector 31 photoelectrically converts light entering the intrinsic semiconductor layer 31c through the upper extrinsic semiconductor layer 31d and the upper electrode layer 31e.

The upper electrode layer 31e is electrically connected to the bias line 14 through an upper contact hole 15. The bias line 14 may be made of a metal such as Ta, Nd, W, Ti, Mo, Al, Cr, or Ag, or an alloy of these metals. The photodetection module 1, 1A, or 1B may include a first passivation layer 16 and a second passivation layer 17 covering the photodetector 31. The first passivation layer 16 and the second passivation layer 17 may be made of, for example, silicon oxide (SiO₂), silicon nitride (SiNx), or an acrylic resin.

The photodetection module 1, 1A, or 1B includes a light-transmissive portion 11 that transmits illumination light L1 emitted from the light source 300 and light-receiving portions 12 that receive scattering light L2 scattered by a medium 800. The light-transmissive portion 11 may be between pixel units 3 adjacent to each other. The light-receiving portions 12 may be at the pixel units 3 each including the photodetector 31.

The container 200 contains the medium 800 including samples 700. The container 200 is made of an optically transparent material, such as a plastic material or a glass material, to be observable from outside. The container 200 may have any shape and size. As illustrated in, for example, FIG. 7, the container 200 may include a lid 201. The container 200 may include multiple container portions for containing the samples 700 and the medium 800. The container 200 may or may not have a bottom. When the container 200 has no bottom, the container 200 may be in close contact with the slit member 400 to hold the medium 800.

Examples of the samples 700 include animal cells, plant cells, yeast cells, and bacterial cells. For the samples 700 being cells, the medium 800 may be a culture medium.

The light source 300 emits illumination light L1 toward the medium 800 contained in the container 200. The light source 300 may include, for example, an LED, an LD, an organic electroluminescence (OEL) element, or a cold-cathode fluorescence lamp (CCFL). The light source 300 may be a surface emitter including light emitters such as LEDs, LDs, and OEL elements in a matrix. The light source 300 may include a diffuser plate or a light guide plate. The light source 300 may be an end-face emitter including at least one light source element on an end face of a light guide plate.

The slit member 400 includes a slit 401 and light shields 402. A part of illumination light L1 emitted from the light source 300 is transmitted through the light-transmissive portion 11 in the optical semiconductor module 1, 1A, or 1B, and is scattered by the medium 800 contained in the container 200. The scattering light L2 scattered by the medium 800 includes vertical scattering light VL2 perpendicular to the horizontal plane. A part of the vertical scattering light VL2 passes through the slit 401 in the slit member 400 and is received by the light-receiving portions 12 in the optical semiconductor module 1, 1A, or 1B. The vertical scattering light VL2 can be scattered by the samples 700. Thus, the amount of light received by the light-receiving portions 12 differs between when the samples 700 are above the slit 401 and when no sample 700 is at a position corresponding to the slit 401. In this manner, the intensity of the vertical scattering light VL2 scattered by the samples 700 can be detected based on the amount of light received by the light-receiving portions 12. This allows detection of any sample 700 above the slit 401.

The light shields 402 in the slit member 400 reduce the likelihood that light other than the light perpendicular to the horizontal plane scattered by the samples 700 and the medium 800 passes through the slit 401 and is received by the light-receiving portions 12. The light shields 402 may be made of a light-shielding material on a surface of a transparent substrate such as a glass substrate or a plastic substrate.

Each light shield 402 may include a first light shield and a second light shield. The first light shield and the second light shield may be spaced from each other in the thickness direction of the substrate 2 (vertical direction in FIG. 8). The first light shield and the second light shield may have substantially the same shape. The first light shield and the second light shield may be located substantially at the same position in a plan view. The light shield 402 including the first light shield and the second light shield reduces the likelihood that the scattering light L2 other than the vertical scattering light VL2 passes through the slit member 400 and is received by the light-receiving portions 12.

The control board 500 includes a radiator 501. The radiator 501 radiates electromagnetic waves toward the antenna wiring 7 in the photodetection module 1, 1A, or 1B. The radiator 501 may include a looped wire similarly to or in the same manner as the antenna wiring 7. The radiator 501 may produce a temporally-variable magnetic flux in an area surrounded by the antenna wiring 7.

The control board 500 transmits data about the amount of the samples 700 obtained by the photodetection module 1, 1A, or 1B to a monitor 900. The control board 500 and the monitor 900 may be connected either with a wire or wirelessly. The control board 500 may include a rechargeable battery, a charging control integrated circuit, an impedance matching circuit, an RF reader integrated circuit, a microcomputer, a nonvolatile memory, and a control integrated circuit.

The monitor 900 receives data transmitted from the control board 500. The monitor 902 may include a control integrated circuit, a microcomputer, and a field-programmable gate array (FPGA).

The monitor 900 may be connected to a computer system 901 and transmit the received data to the computer system 901. The computer system 901 may include a display to display the received data.

The flexible printed circuit board 600 electrically connects some of the external connection terminals 5 in the photodetection module 1, 1A, or 1B to the control board 500. The flexible printed circuit board 600 may be a known flexible printed circuit board including an insulating and flexible base film to which a conductive metal such as Cu foil is attached to form an electric circuit.

The sample observation apparatus 100 according to the present embodiment including the photodetection module 1, 1A, or 1B allows accurate observation of the samples 700.

The optical semiconductor module according to one or more embodiments of the present disclosure may be implemented in forms (1) to (10) described below.
(1) An optical semiconductor module, comprising:
   a substrate including a first surface;
   a plurality of pixel units in a matrix on the first surface, each of the plurality of pixel units including an optical semiconductor component;
   a drive circuit on the first surface, the drive circuit being configured to provide a power supply voltage to the plurality of pixel units and transmit or receive an image signal to or from the plurality of pixel units;
   a plurality of external connection terminals on the first surface;
   a plurality of drive wires on the first surface, the plurality of drive wires connecting the drive circuit and the plurality of external connection terminals; and
   antenna wiring being looped, the antenna wiring surrounding the plurality of pixel units, the drive circuit, the plurality of external connection terminals, and the plurality of drive wires in a plan view, the antenna wiring including two ends connected to the drive circuit.
(2) The optical semiconductor module according to (1), wherein
   the antenna wiring includes front wiring on the first surface, and the front wiring extends along a periphery of the first surface.
(3) The optical semiconductor module according to (1) or (2), wherein
   the substrate includes a second surface opposite to the first surface, and
   the antenna wiring includes back wiring on the second surface, and the back wiring extends along a periphery of the second surface.
(4) The optical semiconductor module according to any one of (1) to (3), wherein
   the substrate includes a third surface connecting the first surface and the second surface, and
   the antenna wiring includes side wiring on the third surface, and the side wiring extends along a periphery of the substrate.
(5) The optical semiconductor module according to any one of (1) to (4), wherein
   the antenna wiring generates the power supply voltage to be provided to the plurality of pixel units.
(6) The optical semiconductor module according to any one of (1) to (5), wherein
   the two ends of the antenna wiring are connected to intermediate terminals located adjacent to the plurality of external connection terminals.
(7) The optical semiconductor module according to (6), wherein
   the intermediate terminals are between the plurality of external connection terminals.
(8) The optical semiconductor module according to any one of (1) to (7), wherein the substrate is a rectangular plate, and
   the plurality of external connection terminals is adjacent to a side of the first surface.
(9) The optical semiconductor module according to any one of (1) to (8), further comprising:
   an insulating layer on the first surface, the insulating layer covering the plurality of pixel units, the drive circuit, the plurality of drive wires, and the antenna wiring.
(10) The optical semiconductor module according to (9), wherein
   the insulating layer includes a low capacitance portion and a high capacitance portion, and the low capacitance portion is between the plurality of external connection terminals and the side.
   The optical semiconductor module according to one or more embodiments of the present disclosure may be implemented in form (11) described below.
(11) A sample observation apparatus, comprising:
   the optical semiconductor module according to any one of (1) to (10);
   a transparent container to contain a medium including a sample;
   a light source configured to emit light toward the transparent container;
   a slit member configured to allow passage of scattering light resulting from the light being scattered by the medium;
   a control board including a radiator configured to radiate an electromagnetic wave toward the antenna wiring; and
   a flexible printed circuit board connecting the optical semiconductor module and the control board,
   wherein the optical semiconductor component includes a photodetector, and
   the optical semiconductor module is located between the light source and the slit member to receive the scattering light passing through the slit member.

Although the optical semiconductor module and the sample observation apparatus according to one or more embodiments of the present disclosure have been described in detail, the optical semiconductor module and the sample observation apparatus according to one or more embodiments of the present disclosure are not limited to the embodiments described above, and may be changed or varied in various manners without departing from the spirit and scope of the present disclosure. The components described in the above embodiments may be entirely or partially combined as appropriate unless any contradiction arises. The optical semiconductor module 1, 1A, or 1B may include the optical semiconductor component 31 that is a light emitter. In this case, the optical semiconductor module 1, 1A, or 1B can be a light-emitting module with less display non-uniformity. Each pixel unit 3 in the optical semiconductor module 1, 1A, or 1B may include, in addition to the optical semiconductor component 31, at least one selected from the group consisting of a pH sensor, a temperature sensor, an electrical resistance sensor, a pressure sensor, a magnetic sensor, a humidity sensor, a chromaticity sensor, and an illuminance sensor.

In one or more embodiments of the present disclosure, the optical semiconductor module includes the efficiently located drive circuit and can be smaller. In one or more embodiments of the present disclosure, the optical semiconductor module includes the pixel units and the antenna wiring that can operate stably.

In one or more embodiments of the present disclosure, the sample observation apparatus includes the above optical semiconductor module and thus allows accurate observation of samples.

The present disclosure may be embodied in various forms without departing from the spirit or the main features of the present disclosure. The embodiments described above are thus merely illustrative in all respects. The scope of the present disclosure is defined not by the description given above but by the claims. Any variations and alterations contained in the claims fall within the scope of the present disclosure.

### REFERENCE SIGNS

1, 1A, 1B optical semiconductor module (photodetection module)
2 sub strate
2a first surface
2aa first side
2b second surface
2c third surface
3 pixel unit
31 optical semiconductor component (photodetector)
31a lower electrode layer
31b lower extrinsic semiconductor layer
31c intrinsic semiconductor layer
31d upper extrinsic semiconductor layer
31e upper electrode layer
32 charge storage
33 switching element (TFT)
33a source electrode
33b drain electrode
33c gate electrode
33d semiconductor film
33e gate insulating film
4 drive circuit
41 gate driver
42 selector
5 external connection terminal
51, 52 intermediate terminal
6 drive wire
7 antenna wiring
7a front wiring
7b back wiring
7c side wiring
7d feedthrough conductor
71, 72 end
73 overlapping area
81 insulating layer
82 insulating layer
82a low capacitance portion
82b high capacitance portion
10 lower contact hole
10a insulating filler
11 light-transmissive portion
12 light-receiving portion
13 external circuit board
14 bias line
15 upper contact hole
16 first passivation layer
17 second passivation layer
100 sample observation apparatus
200 container
201 lid
300 light source
400 slit member
401 slit
402 light shield
500 control board
501 radiator
600 flexible printed circuit board
700 sample
800 medium
900 monitor
901 computer system
902 monitor

## Claims

1. An optical semiconductor module, comprising:
a substrate including a first surface;
a plurality of pixel units in a matrix on the first surface, each of the plurality of pixel units including an optical semiconductor component;
a drive circuit on the first surface, the drive circuit being configured to provide a power supply voltage to the plurality of pixel units and transmit or receive an image signal to or from the plurality of pixel units;
a plurality of external connection terminals on the first surface;
a plurality of drive wires on the first surface, the plurality of drive wires connecting the drive circuit and the plurality of external connection terminals; and
antenna wiring being looped, the antenna wiring surrounding the plurality of pixel units, the drive circuit, the plurality of external connection terminals, and the plurality of drive wires in a plan view, the antenna wiring including two ends connected to the drive circuit.

2. The optical semiconductor module according to claim 1, wherein
the antenna wiring includes front wiring on the first surface, and the front wiring extends along a periphery of the first surface.

3. The optical semiconductor module according to claim 1 or claim 2, wherein
the substrate includes a second surface opposite to the first surface, and
the antenna wiring includes back wiring on the second surface, and the back wiring extends along a periphery of the second surface.

4. The optical semiconductor module according to any one of claims 1 to 3, wherein
the substrate includes a third surface connecting the first surface and the second surface, and
the antenna wiring includes side wiring on the third surface, and the side wiring extends along a periphery of the substrate.

5. The optical semiconductor module according to any one of claims 1 to 4, wherein the antenna wiring generates the power supply voltage to be provided to the plurality of pixel units.

6. The optical semiconductor module according to any one of claims 1 to 5, wherein the two ends of the antenna wiring are connected to intermediate terminals located adjacent to the plurality of external connection terminals.

7. The optical semiconductor module according to claim 6, wherein
the intermediate terminals are between external connection terminals of the plurality of external connection terminals.

8. The optical semiconductor module according to any one of claims 1 to 7, wherein
the substrate is a rectangular plate, and
the plurality of external connection terminals is adjacent to a side of the first surface.

9. The optical semiconductor module according to any one of claims 1 to 8, further comprising:
an insulating layer on the first surface, the insulating layer covering the plurality of pixel units, the drive circuit, the plurality of drive wires, and the antenna wiring.

10. The optical semiconductor module according to claim 9, wherein
the insulating layer includes a low capacitance portion and a high capacitance portion, and the low capacitance portion is between the plurality of external connection terminals and the side.

11. A sample observation apparatus, comprising:
the optical semiconductor module according to any one of claims 1 to 10;
a transparent container to contain a medium including a sample;
a light source configured to emit light toward the transparent container;
a slit member configured to allow passage of scattering light resulting from the light being scattered by the medium;
a control board including a radiator configured to radiate an electromagnetic wave toward the antenna wiring; and
a flexible printed circuit board connecting the optical semiconductor module and the control board,
wherein the optical semiconductor component includes a photodetector, and
the optical semiconductor module is located between the light source and the slit member to receive the scattering light passing through the slit member.
